# EUROPEAN PATENT SPECIFICATION

(11) **EP 0 802 570 B1**
(45) Date of publication and mention of the grant of the patent: **04.08.2004**
(21) Application number: 97105136.2
(22) Date of filing: 26.03.1997
(51) Int. Cl.: H01L 29/778, H01L 29/36

(54) **Double heterojunction field-effect transistor**
Doppelheteroübergang-Feldeffekttransistor
Transistor à effet de champ à double hétérojonction

(30) Priority: 18.04.1996 JP 12097496
(43) Date of publication of application: 22.10.1997
(73) Proprietor: HONDA GIKEN KOGYO KABUSHIKI KAISHA, Minato-ku Tokyo (JP)
(72) Inventor: Suzuki, Toshifumi, Wako-shi, Saitama-ken (JP); Ishikawa, Yamato, Wako-shi, Saitama-ken (JP)
(74) Representative: Herzog, Markus, Dipl.-Phys. Dr.

(56) References cited:
- PATENT ABSTRACTS OF JAPAN vol. 096, no. 012, 26 December 1996 -& JP 08 213594 A (HONDA MOTOR CO LTD), 20 August 1996,
- WEI-CHOU HSU ET AL: "High performance symmetric double delta -doped GaAs/InGaAs/GaAs pseudomorphic HFETs grown by MOCVD" IEEE TRANSACTIONS ON ELECTRON DEVICES, MARCH 1994, USA, vol. 41, no. 3, ISSN 0018-9383, pages 456-457, XP002065482
- DATABASE WPI Week 9610 Derwent Publications Ltd., London, GB; AN 96-096647 XP002065486 -& TW 266 314 A (NAT SCI COMMITTEE) , 21 December 1995 -& US 5 652 440 A (CHANG C) 29 July 1997
- L. D. NGUYEN, ET AL.: "INFLUENCE OF QUANTUM-WELL WIDTH ON DEVICE PERFORMANCE OF Al0.30Ga0.70As/In0.25Ga0.75As (ON GaAs) MODFET'S" IEEE TRANSACTIONS ON ELECTRON DEVICES, vol. 26, no. 5, May 1989, NEW YORK (US), pages 833-838, XP000099014

## Description

The present invention relates to a field-effect transistor having a double-heterojunction structure and more particularly to a field-effect transistor with improved mutual conductance characteristics.

A transistor having a superlative structure which was first invented by Mr. Mimura of Fujitsu Limited is known as HEMT (see U.S. patent Re. 33,584), and is widely used as an essential circuit component in portable telephone sets.

Field-effect transistors (FETs) having a double-heterojunction structure with improved high-frequency characteristics of the HEMT invented by Mr. Mimura have been proposed in Japanese laid-open patent publications Nos. 1-128473 and 1-143271, and are called pseudomorphic-HEMTs. The field-effect transistors have a channel layer and upper and lower wide-band gap layers (electron supply layers) disposed respectively over and beneath the channel layer.

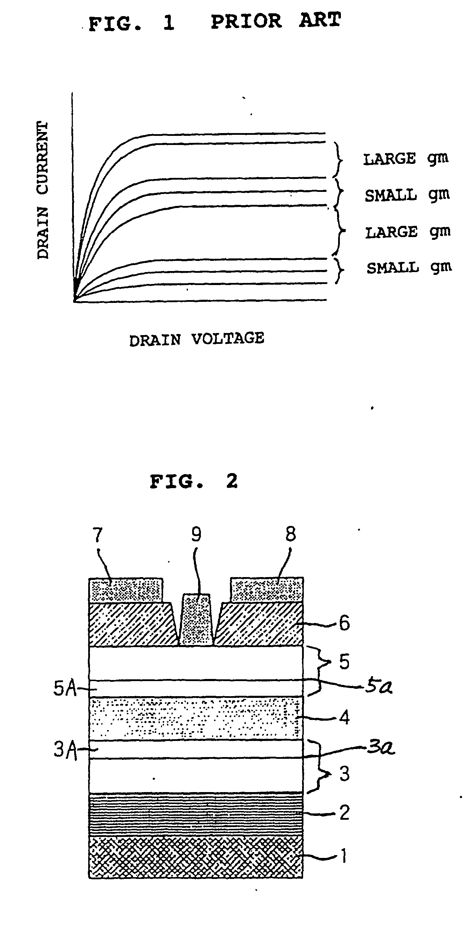

FIG. 1 of the accompanying drawings is a graph showing experimental data on the relationship between the drain voltage and the drain current of the above field-effect transistors with the gate voltage used as a parameter. FIG. 1 shows a plurality of characteristic curves at different gate voltages. As can be seen from FIG. 1, the conventional field-effect transistors are problematic in that their mutual conductance gm remains uniform at the different gate voltages.

In order to eliminate the conventional drawback, it has been customary to make the concentration of a doped impurity in the upper wide-band gap layer greater than the concentration of a doped impurity in the lower wide-band gap layer greater, or making the band gap of the upper wide-band gap layer greater than the band gap of the lower wide-band gap layer greater for thereby uniformizing the mutual conductance gm at the different gate voltages.

However, if the mutual conductance gm is uniformized at the different gate voltages by individually adjusting the impurity concentrations and the band gaps, then the mutual conductance gm is reduced. Therefore, it has been difficult to both increase the mutual conductance gm and uniformize the mutual conductance gm.

It is therefore an object of the present invention to provide a field-effect transistor whose mutual conductance is high and uniform in a wide range of gate voltages.

According to an aspect of the present invention, there is provided a field-effect transistor as defined in claim 1.

In the above field-effect transistor, the upper and lower wide-band gap layers include respective doped planar layers positioned vertically symmetrical with respect to the channel layer and doped with an impurity at the same concentration, and the thickness of the channel layer is in the range of from 50 Å to 150 Å (10Å = 1nm). The upper wide-band gap layer includes a low-resistance wide-band gap layer.

The thickness of the channel layer is of a value (50 Å ∼ 150 Å) substantially equal to the thickness of a single two-dimensional electron gas layer. Therefore, upper and lower two-dimensional electron gas layers developed in the channel layer can be regarded as a single two-dimensional electron gas layer. The field-effect transistor has a high and uniform mutual conductance which is achieved in a wide range of gate voltages without adjusting the composition and impurity concentration of the upper and lower wide-band gap layers.

With the channel layer being thus thin (50 Å ∼ 150 Å) and the doped planar layers being positioned vertically symmetrically with respect to the channel layer, the field-effect transistor has a high mutual conductance and a uniform inductance with respect to gate voltages.
FIG. 1 is a graph showing experimental data on the relationship between the drain voltage and the drain current of a conventional field-effect transistor with the gate voltage used as a parameter;
FIG. 2 is a fragmentary cross-sectional view of a field-effect transistor;
FIG. 3 is a graph showing experimental data on the relationship between the drain voltage and the drain current of the field-effect transistor shown in FIG. 2 at different gate voltages;
FIG. 4 is a graph showing experimental data on the relationship between the mutual conductance and the gate voltage of the field-effect transistor shown in FIG. 2 and other conventional high electron mobility transistors; and
FIG. 5 is a fragmentary cross-sectional view of a field-effect transistor according to the present invention.

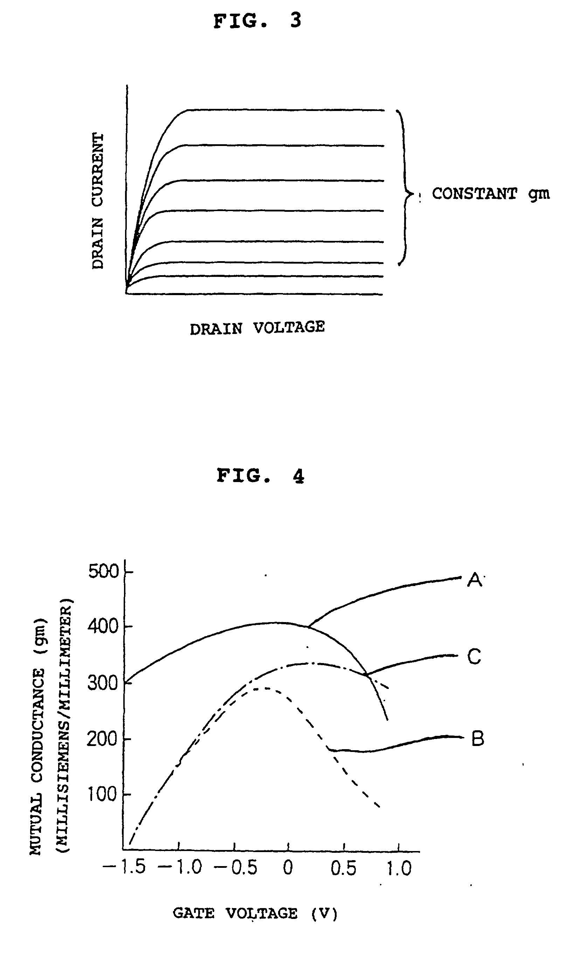

As shown in FIG. 2, a field-effect transistor which is not part of the present invention has a semi-insulating GaAs substrate 1, a superlattice buffer layer 2 disposed on the semi-insulating GaAs substrate 1 for preventing an unwanted carrier from leaking, and a double-heterojunction structure disposed on the superlattice buffer layer 2 and having a pair of lower and upper wide-band gap layers 3, 5 and a channel layer 4 disposed between the lower and upper wide-band gap layers 3, 5. The field-effect transistor also includes an n⁺ contact layer 6 disposed on the upper wide-band gap layer 5, a source electrode 7 disposed on the n⁺ contact layer 6, a drain electrode 8 disposed on the n⁺ contact layer 6, and a gate electrode 9 disposed on the upper wide-band gap layer 5.

The wide-band gap layer 3 disposed on the superlattice buffer layer 2 and forming a heterojunction with the channel layer 4 has an appropriate thickness and is made of AlₓGa₁₋ₓAs (0.2 < x < 0.3). The wide-band gap layer 3 includes a silicon-doped planar layer 3a which is spaced by a spacer layer 3A of a certain thickness from the heterojunction between the wide-band gap layer 3 and the channel layer 4. The silicon-doped planar layer 3a is doped with an impurity of silicon (Si) at a concentration of 1 - 10 × 10¹² cm⁻². The spacer layer 3A is made of AlₓGa₁₋ₓAs (0.2 < x < 0.3).

The channel layer 4 is disposed on the spacer layer 3A. The channel layer 4 is made of InGaAs and has a thickness ranging from about 50 Å to 150 Å. The thickness of the channel layer 4 is selected to be of such a value as to cause two electron gas layers, which would otherwise be separated in the channel layer 4, to be combined into a single electron gas layer, and also as to keep the single electron gas layer in the channel layer 4 irrespective of whether a voltage is not applied to the gate electrode 9 (normal state) or a voltage is applied to the gate electrode 9.

The wide-band gap layer 5 disposed on the channel layer 4 and forming a heterojunction with the channel layer 4 is made of AlₓGa₁₋ₓAs (0.2 < x < 0.3) and has a thickness ranging from about 250 to 350 Å which is selected to allow a depeletion layer developed by the gate electrode 9 to affect the channel layer 4. The wide-band gap layer 5 includes a silicon-doped planar layer 5a which is spaced by a spacer layer 5A, which is at most 40 Å thick, from the heterojunction between the wide-band gap layer 5 and the channel layer 4. The silicon-doped planar layer 5a is doped with an impurity of silicon (Si) at a concentration of 1 - 10 × 10¹² cm⁻². The spacer layer 5A is made of AlₓGa₁₋ₓAs (0.2 < x < 0.3).

Therefore, the thickness of the spacer layer 5A is the same as the thickness of the spacer layer 3A, and the concentration of the impurity doped in the silicon-doped planar layer 5a is the same as the concentration of the impurity doped in the silicon-doped planar layer 3a. The composition ratios of the respective materials AlₓGa₁₋ₓAs of the wide-band gap layers 3, 5 are identical to each other. The spacer layers 3A, 5A may be dispensed with, and the heterojunctions may be doped with a player layer of the impurity.

Since the wide-band gap layers 3, 5 are vertically symmetrical with respect to each other with respect to the channel layer 4, and the channel layer 4 of InGaAs has the thickness selected as described above, the mutual conductance gm of the field-effect transistor can vary at uniform rates of change when the voltage applied to the gate electrode 9, i.e., the gate voltage, is varied.

The source electrode 7 and the drain electrode 8 are mounted on the n⁺ contact layer 6 which is disposed on the wide-band gap layer 5 for better ohmic contact. The gate electrode 9 is positioned between two lands of the n⁺ contact layer 6, and any gap between the lower end of the gate electrode 9 and the n⁺ contact layer 6 should preferably be of a very small dimension of 0.1 millimeter or less, for example.

FIG. 3 is a graph showing experimental data on the relationship between the drain voltage and the drain current of the field-effect transistor shown in FIG. 2 at different gate voltages as a parameter. It can be seen from FIG. 3 that rates of change of the drain current when the gate voltage is varied at constant intervals are uniform, and hence the mutual conductance gm is uniform in a wide range of gate voltages.

FIG. 4 is a graph showing experimental data on the relationship between the mutual conductance gm and the gate voltage of the field-effect transistor shown in FIG. 2 and other conventional field-effect transistors. The vertical axis of the graph represents the mutual conductance (gm) per unit gate width and the horizontal axis the gate voltage. A solid-line curve A indicates the data of the field-effect transistor according to the first embodiment of the present invention. A dotted-line curve B indicates the data of a conventional field-effect transistor. A dot-and-dash-line curve C indicates the data of an improved conventional field-effect transistor in which the doped concentration and band gap of the upper wide-gap layer (electron supply layer) 5 are larger than those of the lower wide-gap layer (electron supply layer) 3. The experimental data shown in FIG. 4 that the mutual conductance gm of the field-effect transistor according to the first embodiment is greater than those of the conventional field-effect transistors.

The thickness (50 Å ∼ 150 Å) of the channel layer 4 of InGaAs is selected to be substantially equal to the thickness of a single two-dimensional electron gas layer. Two two-dimensional electron gas layers which are produced in the channel layer 4 by the two heterojunctions have the same carrier density, and can be regarded as a single electron gas layer in the channel layer 4. As described above, the composition ratios of the upper and lower wide-band gap layers 5, 3 and the impurity concentrations in these layers are equal to each other in the vertically symmetrical double-heterojunction structure. This allows the field-effect transistor to have a uniform mutual conductance in a wide range of gate electrodes.

Since the composition ratios of the upper and lower wide-band gap layers 5, 3 and the impurity concentrations in these layers are equal to each other in the vertically symmetrical double-heterojunction structure, conditions to be kept in a fabrication process for the field-effect transistor can be controlled with ease, resulting in a higher production yield and smaller characteristic variations of field-effect transistors.

The channel layer 4 of InGaAs is of a very small thickness ranging from 50 Å to 150 Å and the silicon-doped planar layers are positioned in a vertically symmetrical pattern with respect to the channel layer 4. With this arrangement, the field-effect transistor has a high mutual conductance achieved by a channel having a single high carrier density and also has inductance characteristics that are uniform with respect to the gate voltage.

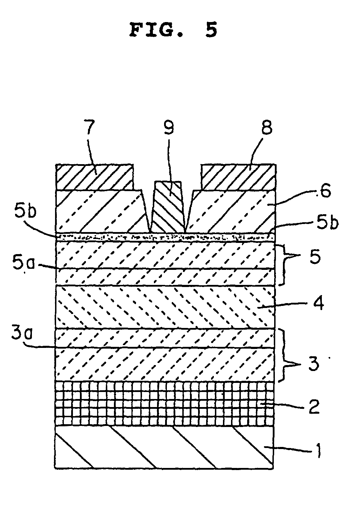

FIG. 5 shows a field-effect transistor according to the present invention.

As shown in FIG. 5, the field-effect transistor, constructed as a high electron mobility transistor, according to the invention has a semi-insulating GaAs substrate 1, a superlattice buffer layer 2 disposed on the semi-insulating GaAs substrate 1, a double-heterojunction structure disposed on the superlattice buffer layer 2 and including a pair of lower and upper high-resistance AlGaAs wide-band gap layers 3, 5 and an InGaAs channel layer 4 disposed between the lower and upper AlGaAs wide-band gap layers 3, 5, an n⁺ contact layer 6 disposed on the upper AlGaAs wide-band gap layer 5, a source electrode 7 disposed on the n⁺ contact layer 6, a drain electrode 8 disposed on the n⁺ contact layer 6, and a gate electrode 9 disposed on the upper AlGaAs wide-band gap layer 5.

The superlattice buffer layer 2 disposed on the semi-insulating GaAs substrate 1 serves to prevent an unwanted carrier from leaking. The AlGaAs wide-band gap layer 3 disposed on the superlattice buffer layer 2 has a thickness of about 330 Å and is made of AlₓGa₁₋ₓAs (0.2 < x < 0.3). The AlGaAs wide-band gap layer 3 includes a silicon-doped planar layer 3a which contains an impurity of silicon (Si) at an areal density of 2.5 × 10¹² cm⁻² and which is positioned at a location that is 30 Å spaced from the heterojunction between the AlGaAs wide-band gap layer 3 and the channel layer 4.

The channel layer 4 has a thickness which is selected to be of a value small enough to cause two electron gas layers, which would otherwise be separated away from each other in the vicinity of heterojunctions formed between the channel layer 4 and the lower and upper AlGaAs wide-band gap layers 3, 5, to be combined into a single electron gas layer that is controllable depending on changes in the gate voltage applied to the gate electrode. Specifically, the thickness of the channel layer 4 is in the range of from 50 Å to 150 Å.

The AlGaAs wide-band gap layer 5 disposed on the channel layer 4 has a thickness of about 250 Å and is made of AlₓGa₁₋ₓAs (0.2 < x < 0.3) The AlGaAs wide-band gap layer 5 also includes a silicon-doped planar layer 5a which contains an impurity of Si at an areal density of 2.5 × 10¹² cm⁻² and which is positioned at a location that is 30 Å spaced from the heterojunction between the AlGaAs wide-band gap layer 5 and the channel layer 4. Therefore, the channel layer 4 and the lower and upper AlGaAs wide-band gap layers 3, 5 are of a vertically symmetrical structure with respect to the horizontal central axis of the channel layer 4.

According to the embodiment, the AlGaAs wide-band gap layer 5 includes a low-resistance AlGaAs wide-band gap layer 5b disposed in an upper end region thereof and doped with Si at a concentration ranging from 3 × 10" cm⁻³ to 1 × 10¹⁸ cm⁻³, the low-resistance AlGaAs wide-band gap layer 5b having a thickness ranging from 40 Å to 120 Å and preferably of 80 Å. The n⁺ contact layer 6, which is disposed on the low-resistance AlGaAs wide-band gap layer 5b, is doped with Si at a concentration of 5 × 10¹⁰ cm⁻³ and has a thickness of 500 Å.

Because the low-resistance AlGaAs wide-band gap layer 5b is positioned immediately below the gate electrode 9, when a voltage applied to the gate electrode 9 is low, a depletion layer developed immediately below the gate electrode 9 is prevented from spreading by the low-resistance AlGaAs wide-band gap layer 5b. Specifically, as long as the voltage applied to the gate electrode 9 is low, the depletion layer developed immediately below the gate electrode 9 does not spread through the wide-band gap layer 5b into the lower region of the AlGaAs wide-band gap layer 5. Therefore, the high electron mobility transistor is in a normally-on state.

Because the thickness of the low-resistance AlGaAs wide-band gap layer 5b is of a relatively small value of 80 Å, when the voltage applied to the gate electrode 9 varies, the depletion layer developed immediately below the gate electrode 9 spreads quickly through the wide-band gap layer 5b into the lower region of the AlGaAs wide-band gap layer 5, starting to affect the behavior of an electron gas produced in the channel layer 4.

When the voltage applied to the gate electrode 9, i.e., the gate voltage, varies, the spreading of the depeletion layer, more precisely, a change in the potential of each of regions in the vicinity of the channel layer 4, varies to a greater degree as the resistance of the wide-band gap layer 5 increases. The greater the variation in the spreading of the depeletion layer per unit gate voltage becomes with respect to the width of the channel layer 4, the greater the tendency of the gate voltage to affect the channel layer 4, causing the electron gas in the channel layer 4 to behave in a more integrated manner, so that the high electron mobility transistor has improved mutual conductance characteristics.

As described above, inasmuch as the channel layer 4 has a relatively small thickness and the lower and upper AlGaAs wide-band gap layers 3, 5 positioned adjacent to the channel layer 4 have a relatively high resistance, the electron gas produced in the channel layer 4 is both physically integrated by the thickness of the channel layer 4 and functionally integrated by the high resistance of the AlGaAs wide-band gap layers 3, 5 adjacent to the channel layer, providing good mutual conductance characteristics. The electron gas thus integrated is highly responsive to the gate voltage, resulting in the improved mutual conductance characteristics.

According to the conventional field-effect transistors disclosed in Japanese laid-open patent publications Nos. 1-128473 and 1-143271, the upper wide-band gap layer, corresponding to the upper wide-band gap layer 5, has a medium resistance value uniformly throughout the upper wide-band gap layer. This is because the upper wide-band gap layer cannot have a relatively large resistance since it is responsible for the supply of electrons into the channel layer.

According to the present invention, however, the silicon-doped planar layers 3a, 5a are fully responsible for supplying electrons into the channel layer 4, and the region of the wide-band gap layer 5 in the vicinity of the channel layer 4 has a considerably high resistance whereas the wide-band gap layer 5b immediately below the gate electrode 9 is considerably thin and has a considerably low resistance. Consequently, adjustments to make the high electron mobility transistor normally-on or normally-off can be made by adjusting the density of the doped impurity and the thickness of the wide-band gap layer 5b. Therefore, the mutual conductance characteristics can be improved and the threshold voltage can be established independently of each other.

In the illustrated embodiment, the wide-band gap layers 3, 5 adjacent to the channel layer 4 have a relatively high resistance and the channel layer 4 has a relatively small thickness limited to a certain range. However, the thickness of the channel layer 4 is defined in claim 1, and the mutual conductance characteristics may be improved by increasing the resistance of the wide-band gap layers 3, 5 adjacent to the channel layer 4, the layers 3 and 5 having high resistance as defined in claim 1.

The wide-band gap layers 3, 5 are made of AlGaAs and the channel layer 4 as a narrow-band gap layer is made of InGaAs.

A field-effect transistor has a double-heterojunction structure including a channel layer of InGaAs and upper and lower wide-band gap layers disposed respectively over and beneath the channel layer and each forming a heterojunction with the channel layer. The channel layer has such a thickness as to develop a substantially single electron gas layer in the channel layer. The upper and lower wide-band gap layers having substantially the same impurity concentration. The upper and lower wide-band gap layers include respective doped planar layers positioned vertically symmetrical with respect to the channel layer and doped with an impurity at the same concentration. The scope of the invention is defined by the appended claims.

## Claims

1. A field effect transistor having a double-heterojunction structure including
- a channel layer (4) of InGaAs,
said channel layer (4) having such a thickness as to develop a substantially single electron gas layer in the channel layer (4),
- an upper wide-bandgap layer (5) disposed above said channel layer (4), and
- a lower wide-bandgap layer (3) disposed beneath said channel layer (4), each of said upper and lower wide-bandgap layers (5, 3) being of a high-resistance AlGaAs type, each of said upper and lower high-resistance wide-bandgap layers (5, 3) forming a heterojunction with the channel layer (4) and having substantially the same impurity concentration, and each of said upper and lower high-resistance wide-bandgap layers (5, 3) includes a silicon-doped planar layer (5a, 3a), and wherein
- an n⁺ contact layer (6) is disposed above said upper wide-bandgap layer (5), a source electrode (7) and a drain electrode (8) being mounted on said n⁺ contact layer, and
- said upper high-resistance wide-bandgap layer (5) includes in an upper end region an AlGaAs type low-resistance wide-bandgap layer (5b), said low-resistance wide-bandgap layer (5b) having a thickness ranging from 4 nm (40Å) to 12 nm (120Å) and having an impurity concentration ranging from 3x10¹⁷ cm⁻³ to 1x10¹⁸ cm⁻³.

2. A field effect transistor according to claim 1,
wherein said one silicon-doped planar layer (5a) in the upper high-resistance wide-bandgap layer (5) containing the same impurity doping concentration and being positioned at the same distance from the channel layer (4) as said other silicon-doped planar layer (3a) in the lower high-resistance wide-bandgap layer (3).

3. A field effect transistor according to claim 1 or 2,
wherein said channel layer (4) has a thickness ranging from 5 nm (50Å) to 15 nm (150Å).

## Patentansprüche

1. Feldeffekttransistor mit einer Doppel-Heteroübergangsstruktur, umfassend:
- eine Kanalschicht (4) aus InGaAs,
wobei die Kanalschicht (4) eine derartige Dicke aufweist, dass sich eine im Wesentlichen einfache Elektronengasschicht in der Kanatschicht (4) ausbildet,
- eine obere Schicht (5) mit größer Bandlücke, die oberhalb der Kanatschicht (4) angeordnet ist, und
- eine untere Schicht (3) mit großer Bandlücke, die unterhalb der Kanalschicht (4) angeordnet ist,
wobei sowohl die obere (5) als auch die untere (3) Schicht mit großer Bandlücke von einem AlGaAs-Typ mit großem Widerstand sind,
wobei sowohl die obere (5) als auch die untere (3) Schicht mit großer Bandlücke und großem Widerstand jeweils einen Heteroübergang mit der Kanalschicht (4) bildet und im Wesentlichen dieselbe Verunreinigungskonzentration aufweist, und
wobei sowohl die obere (5) als auch die untere (3) Schicht mit großer Bandlücke und großem Widerstand jeweils eine siliziumdotierte planare Schicht (5a, 3a) aufweist, und
- wobei eine n⁺-Kontaktschicht (6) oberhalb der oberen (5) Schicht mit großer Bandlücke angeordnet ist, wobei eine Source-Elektrode (7) und eine Drain-Elektrode (8) an der n⁺-Kontaktschicht (6) angebracht sind, und
- wobei die obere Schicht (5) mit großer Bandlücke und großem Widerstand in einem oberen Endbereich eine AlGaAs-Schicht (5b) mit großer Bandlücke und niedrigem Widerstand umfasst, wobei die Schicht (5b) mit großer Bandlücke und niedrigem Widerstand eine Dicke im Bereich von 4 nm (40 Å) bis 12 nm (120 Å) und eine Verunreinigungskonzentration von 3 · 10¹⁷ cm⁻³ bis 1 · 10¹⁸ cm⁻³ aufweist.

2. Feldeffekttransistor nach Anspruch 1, wobei die eine siliziumdotierte planare Schicht (5a) in der oberen Schicht (5) mit großer Bandlücke und großem Widerstand dieselbe Dotierungskonzentration von Verunreinigungen enthält und im selben Abstand von der Kanalschicht (4) angeordnet ist wie die andere siliziumdotierte planare Schicht (3a) in der unteren Schicht (3) mit großer Bandlücke und großem Widerstand.

3. Feldeffekttransistor nach Anspruch 1 oder 2, wobei die Kanalschicht (4) eine Dicke im Bereich von 5 nm (50 Å) bis 15 nm (150 Å) aufweist.

## Revendications

1. Transistor à effet de champ ayant une structure à double hétérojonction, comprenant :
- une couche de canal (4) de InGaAs ;
ladite couche de canal (4) ayant une épaisseur telle qu'elle développe une couche de gaz essentiellement à électron célibataire quasiment unique dans la couche de canal (4) ;
- une couche supérieure de bande interdite large (5) placée au-dessus de ladite couche de canal (4) ; et
- une couche inférieure de bande interdite large (3) placée en dessous de ladite couche de canal (4) ;
chacune desdites couches supérieure et inférieure de bande interdite large (5, 3) étant de type AlGaAs à haute résistance, chacune desdites couches supérieure et inférieure de bande interdite large à haute résistance (5, 3) formant une hétérojonction avec la couche de canal (4) et ayant sensiblement la même concentration en impuretés, et chacune desdites couches supérieure et inférieure de bande interdite large à haute résistance (5, 3) comprenant une couche plane dopée au silicium (5a, 3a) ; et dans lequel
- une couche de contact n⁺ (6) est placée au-dessus de ladite couche supérieure de bande interdite large (5), une électrode de source (7) et une électrode de drain (8) étant montées sur ladite couche de contact n⁺ ; et
- ladite couche supérieure de bande interdite large à haute résistance (5) comprend, dans une région d'extrémité supérieure, une couche de bande interdite large à faible résistance de type AlGaAs (5b), ladite couche de bande interdite large à faible résistance (5b) ayant une épaisseur allant de 4 nm (40 Å) à 12 nm (120 Å) et ayant une concentration en impuretés allant de 3 x 10¹⁷ à 1 x 10¹⁸ cm⁻³.

2. Transistor à effet de champ selon la revendication 1, dans lequel ladite une couche plane dopée au silicium (5a) de la couche supérieure de bande interdite large à haute résistance (5) contient la même concentration de dopage en impuretés et est placée à la même distance de la couche de canal (4) que ladite autre couche plane dopée au silicium (3a) de la couche inférieure de bande interdite large à haute résistance (3).

3. Transistor à effet de champ selon la revendication 1 ou 2, dans lequel ladite couche de canal (4) a une épaisseur allant de 5 nm (50 Å) à 15 nm (150 Å).
